# EUROPEAN PATENT SPECIFICATION

(11) **EP 0 839 323 B1**
(45) Date of publication and mention of the grant of the patent: **25.08.2004**
(21) Application number: 97926653.3
(22) Date of filing: 15.05.1997
(51) Int. Cl.: G01R 1/067, G01R 1/073

(54) **MICROELECTRONIC SPRING CONTACT ELEMENTS**
MIKROELEKTRONISCHES FEDERKONTAKTELEMENT
ELEMENTS MICRO-ELECTRONIQUES DE CONTACT A RESSORT

(30) Priority: 17.05.1996 US 5189 P; 24.05.1996 WO PCT/US81/00007; 27.06.1996 US 20869 P; 22.08.1996 US 24405 P; 26.08.1996 US 24555 P; 13.11.1996 US 30697 P; 13.12.1996 US 32666 P; 31.12.1996 US 34053 P; 15.01.1997 US 784862; 24.01.1997 US 788740; 18.02.1997 US 802054; 17.03.1997 US 819464; 06.05.1997 US 852152
(43) Date of publication of application: 06.05.1998
(60) Divisional application: 04014364.6
(73) Proprietor: FormFactor, Inc., Livermore, CA 94550 (US)
(72) Inventor: KHANDROS, Igor, Y., Orinda, CA 94563 (US); ELDRIDGE, Benjamin, N., Danville, CA 94526 (US); MATHIEU, Gaetan, L., Livermore, CA 94550 (US); PEDERSEN, David, V., Scotts Valley, CA 95066 (US)
(74) Representative: Käck, Jürgen, Dipl.-Ing.
(86) International application number: PCT/US1997/008634
(87) International publication number: WO 1997/043654

(56) References cited:
- EP-A- 0 457 253
- WO-A-95/14314
- US-A- 5 391 521
- US-A- 5 475 318
- LEUNG J ET AL: "ACTIVE SUBSTRATE MEMBRANE PROBE CARD" TECHNICAL DIGEST OF THE INTERNATIONAL ELECTRON DEVICES MEETING (IEDM), WASHINGTON, DEC. 10 - 13, 1995, 10 December 1995, INSTITUTE OF ELECTRICAL AND ELECTRONIC ENGINEERS, pages 709-712, XP000624791

## Description

### TECHNICAL FIELD OF THE INVENTION

The present invention relates to resilient (spring) contact (interconnection) elements (structures) suitable for effecting pressure and/or compliant connections between electronic components and, more particularly, to microminiature spring contact elements.

### CROSS-REFERENCE TO RELATED APPLICATIONS

This patent application is a continuation-in-part of commonly-owned, copending U.S. Patent Application No. 60/030,697 filed 13 Nov 96.

This patent application is also a continuation-in-part of commonly-owned, copending U.S. Patent Application No. 08/452,255 (hereinafter "PARENT CASE") filed 26 May 95 and its counterpart PCT patent application number **PCT/US95/14909** filed 13 NOV 95, both of which are continuations-in-part of commonly-owned, copending U.S. Patent Application No. **08/340,144** filed 15 Nov 94 and its counterpart PCT patent application number **PCT/US94/13373** filed 16 Nov 94, both of which are continuations-in-part of commonly-owned, copending U.S. Patent Application No. **08/152,812** filed 16 Nov 93 (now **USP 5,476,211,** 19 Dec 95).

This patent application is also a continuation-in-part of the following commonly-owned, copending U.S. Patent Application Nos. :
**08/554,902** filed 09 NOV 95 (PCT/US95/14844, 13 NOV 95);
**08/558,332** filed 15 NOV 95 (PCT/US95/14885, 15 NOV 95);
**60/012,027** filed 21 FEB 96 (PCT/US96/08117, 24 MAY 96);
**60/005,189** filed 17 MAY 96 (PCT/US96/08107, 24 MAY 96);
**60/024,555** filed 26 Aug 96;
**08/784,862** filed 15 Jan 97;
**08/802,054** filed 18 Feb 97; and
**08/819,464** filed 17 Mar 97,
all of which (other than the provisional patent applications) are continuations-in-part of the aforementioned PARENT CASE.

### BACKGROUND OF THE INVENTION

Commonly-owned U.S. Patent Application No. **08/152,812** filed 16 Nov 93 (now USP 4,576,211, issued 19 Dec 95), and its counterpart commonly-owned copending "divisional" U.S. Patent Applications Nos. **08/457,479** filed 01 Jun 95 (status: pending) and **08/570,230** filed 11 Dec 95 (status: pending), all by KHANDROS, disclose methods for making resilient interconnection elements for microelectronics applications involving mounting an end of a flexible elongate core element (e.g., wire "stem" or "skeleton") to a terminal on an electronic component, coating the flexible core element and adjacent surface of the terminal with a "shell" of one or more materials having a predetermined combination of thickness, yield strength and elastic modulus to ensure predetermined force-to-deflection characteristics of the resulting spring contacts. Exemplary materials for the core element include gold. Exemplary materials for the coating include nickel and its alloys. The resulting spring contact element is suitably used to effect pressure, or demountable, connections between two or more electronic components, including semiconductor devices.

Commonly-owned, copending U.S. Patent Application No. **08/340,144** filed 15 Nov 94 and its corresponding PCT Patent Application No. **PCT/US94/13373** filed 16 Nov 94 (WO95/14314, published 26 May 95), both by KHANDROS and MATHIEU, disclose a number of applications for the aforementioned spring contact element, and also discloses techniques for fabricating contact pads at the ends of the spring contact elements. For example, in Figure 14 thereof, a plurality of negative projections or holes, which may be in the form of inverted pyramids ending in apexes, are formed in the surface of a sacrificial layer (substrate). These holes are then filled with a contact structure comprising layers of material such as gold or rhodium and nickel. A flexible elongate element is mounted to the resulting contact structure and can be overcoated in the manner described hereinabove. In a final step, the sacrificial substrate is removed. The resulting spring contact has a contact pad having controlled geometry (e.g., sharp points) at its free end.

Commonly-owned, copending U.S. Patent Application No. **08/452,255** filed 26 May 95 and its corresponding PCT Patent Application No. **PCT/US95/14909** filed 13 Nov 95 (WO96/17278, published 06 Jun 96), both by ELDRIDGE, GRUBE, KHANDROS and MATHIEU, disclose additional techniques and metallurgies for fabricating contact tip structures on sacrificial substrates, as well as techniques for transferring a plurality of spring contact elements mounted thereto, en masse, to terminals of an electronic component (see, e.g., Figures 11A-11F and 12A-12C therein).

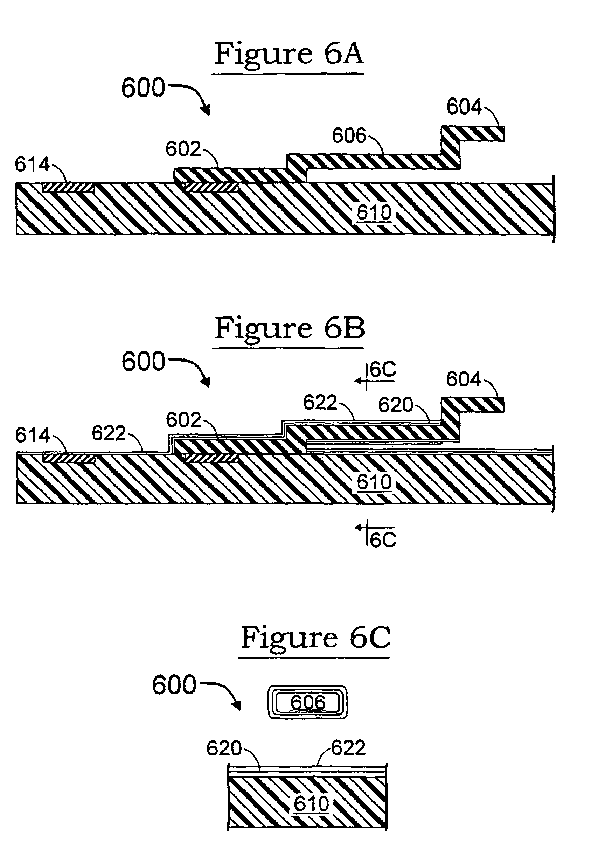

Commonly-owned, copending U.S. Provisional Patent Application No. **60/005,189** filed 17 May 96 and its corresponding PCT Patent Application No. **PCT/US96/08107** filed 24 May 96 (WO96/37332, published 28 Nov 96), both by ELDRIDGE, KHANDROS, and MATHIEU, discloses techniques whereby a plurality of contact tip structures (see, e.g, #620 in Figure 6B therein) are joined to a corresponding plurality of elongate contact elements (see, e.g., #632 of Figure 6D therein) which are already mounted to an electronic component (#630). This patent application also discloses, for example in Figures 7A-7E therein, techniques for fabricating "elongate" contact tip structures in the form of cantilevers. The cantilever tip structures can be tapered, between one end thereof and an opposite end thereof. The cantilever tip structures of this patent application are suitable for mounting to already-existing (i.e., previously fabricated) raised interconnection elements (see, e.g., #730 in Figure 7F) extending (e.g., free-standing) from corresponding terminals of an electronic component (see. e.g., #734 in Figure 7F).

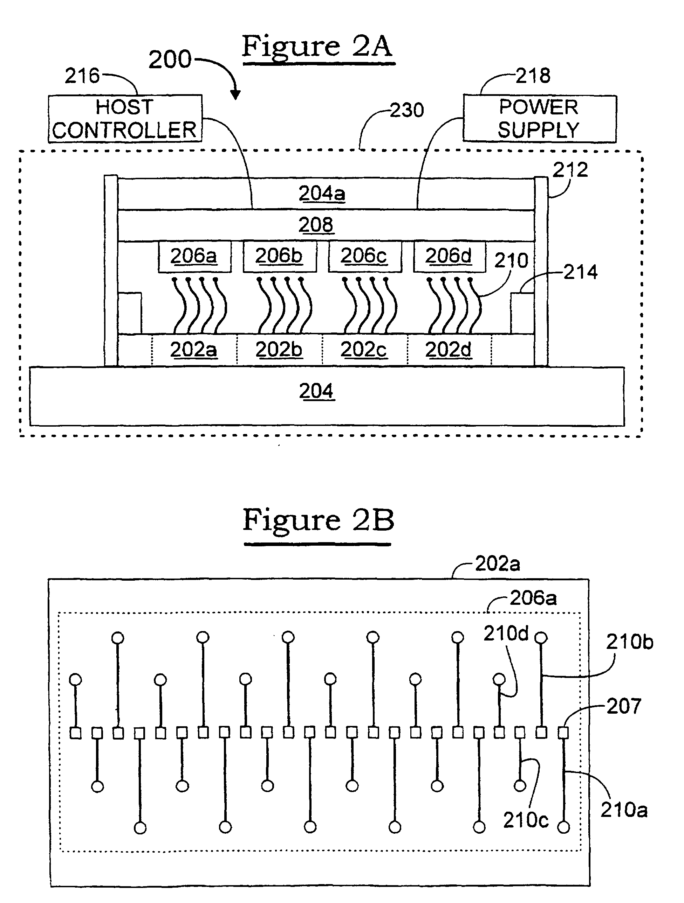

Commonly-owned, copending U.S. Provisional Patent Application No. **60/024,555** filed 26 Aug 96, by ELDRIDGE, KHANDROS and MATHIEU, discloses, for example at Figures 2A-2C thereof, a technique whereby a plurality of elongate tip structures having different lengths than one another can be arranged so that their outer ends are disposed at a greater pitch than their inner ends. Their inner, "contact" ends may be collinear with one another, for effecting connections to electronic components having terminals disposed along a line, such as a centerline of the component.

The present invention addresses and is particularly well-suited to making interconnections to modern microelectronic devices having their terminals (bond pads) disposed at a fine-pitch. As used herein, the term "fine-pitch" refers to microelectronic devices that have their terminals disposed at a spacing of less than 127 µm (5 mils), such as 63.5 µm (2.5 mils) or 65 µm. As will be evident from the description that follows, this is preferably achieved by taking advantage of the close tolerances that readily can be realized by using lithographic rather than mechanical techniques to fabricate the contact elements.

WO 95/14314 A1 discloses resilient contact structures and methods for fabricating the same. The contact structure comprises an elongate part, a base end mountable on a first electronic component and a contact end for contacting a pad of a second electronic component. The contact end is vertically and laterally displaced from the base end wherein the elongate part is bent. This structure provides high elasticity in vertical direction while deformation is avoided when the vertical force is released after pressure contacting.

### SUMMARY OF THE INVENTION

An object of the invention is to provide a technique for fabricating spring contact elements using processes that are inherently well-suited to the fine-pitch close-tolerance world of microelectronics as well as providing a microelectronic spring contact element and a semiconductor device including a plurality of spring contact elements inherently well-suited for fine-pitch connections between terminals restically and laterally displaced to each other.

The invention is defined in claims 1, 7, 13 and 16, respectively.

Particular embodiments are set out in the dependent claims.

According to the invention, a spring contact element is fabricated on an electronic component such as an active semiconductor device by photolithographically defining one or more openings in corresponding one or more masking layers, depositing a conductive metallic mass in the three-dimensional opening(s), then removing the masking layer(s), resulting in a spring contact element which has a base (proximal) end which is adjacent a surface of the component and a contact (distal) end (also "tip end" or "free end") which is both horizontally and vertically spaced apart from the base end. A plurality of spring contact elements can be fabricated in this manner on the component, to photolithographic (extremely fine) tolerances.

The spring contact elements of this invention are suitable for making either temporary or permanent electrical connections to terminals of another electronic component such as a printed circuit board (PCB).

For making temporary connections, the component upon which the spring contact elements are fabricated is brought together with another electronic component so that the tip ends of the spring contact elements are in pressure contact with terminals of the other electronic component. The spring contact elements react resiliently to maintain contact pressure and electrical connections between the two components.

For making permanent connections, the component upon which the spring contact elements are fabricated is brought together with another electronic component, and the tip ends of the spring contact elements are joined, such as by soldering or brazing or with a conductive adhesive, to terminals of the other electronic component. The spring contact elements are compliant, and accommodate differential thermal expansion between the two electronic components.

The spring contact element is suitably formed of at least one layer of a metallic material selected for its ability to cause the resulting contact structure to function, in use, as a spring (i.e., exhibit elastic deformation) when force is applied to its contact (free) end.

The spring contact elements of the present invention can be fabricated directly on the surface of a semiconductor device, or on the surfaces of a plurality of semiconductor devices resident on a semiconductor wafer. In this manner, a plurality of semiconductor devices resident on a semiconductor wafer can be "readied" for burn-in and/or test prior to being singulated from the semiconductor wafer.

Other objects, features and advantages of the invention will become apparent in light of the following description thereof.

### BRIEF DESCRIPTION OF THE DRAWINGS

Reference will be made in detail to preferred embodiments of the invention, examples of which are illustrated in the accompanying drawings. The drawings are intended to be illustrative, not limiting. Although the invention will be described in the context of these preferred embodiments, it should be understood that it is not intended to limit the spirit and scope of the invention to these particular embodiments. Certain elements in selected ones of the drawings are illustrated not-to-scale, for illustrative clarity. Often, similar elements throughout the drawings are referred to by similar references numerals. For example, the element 199 may be similar in many respects to the element 299 in another figure. Also, often, similar elements are referred to with similar numbers in a single drawing. For example, a plurality of elements 199 may be referred to as 199a, 199b, 199c, etc.
**Figure 1A** is a side cross-sectional view of a technique for making a spring contact element, according to the invention.
**Figure 1B** is a side cross-sectional view of the spring contact element of **Figure 1A,** according to the invention.
**Figure 1C** is a perspective view of the spring contact element of **Figure 1B,** according to the invention.
**Figure 2A** is a schematic illustration of a system application for spring contact elements on semiconductor devices, according to the invention.
**Figure 2B** is a schematic plan view of a portion of the system of **Figure 2A**.
**Figure 3A** is a side cross-sectional view of an alternate embodiment of a spring contact element, according to the invention.
**Figure 3B** is a plan view of the spring contact element of **Figure 3A**, according to the invention.
**Figure 3C** is a side cross-sectional view of an alternate embodiment of a spring contact element, according to the invention.
**Figures 4A-4B** are side cross-sectional views illustrating techniques applicable to uniformizing an effective length of a plurality of spring contact elements, according to the invention.
**Figure 5** is a perspective view of an alternate embodiment of a spring contact element, according to the invention.
**Figure 6A** is a side cross-sectional view of a first step in a technique for achieving controlled impedance in a spring contact element, according to the invention.
**Figure 6B** is a side cross-sectional view of a next step in the technique for achieving controlled impedance in a spring contact element, according to the invention.
**Figure 6C** is an end cross-sectional view of the controlled impedance spring contact element of **Figure 6B,** according to the invention.

### DETAILED DESCRIPTION OF THE INVENTION

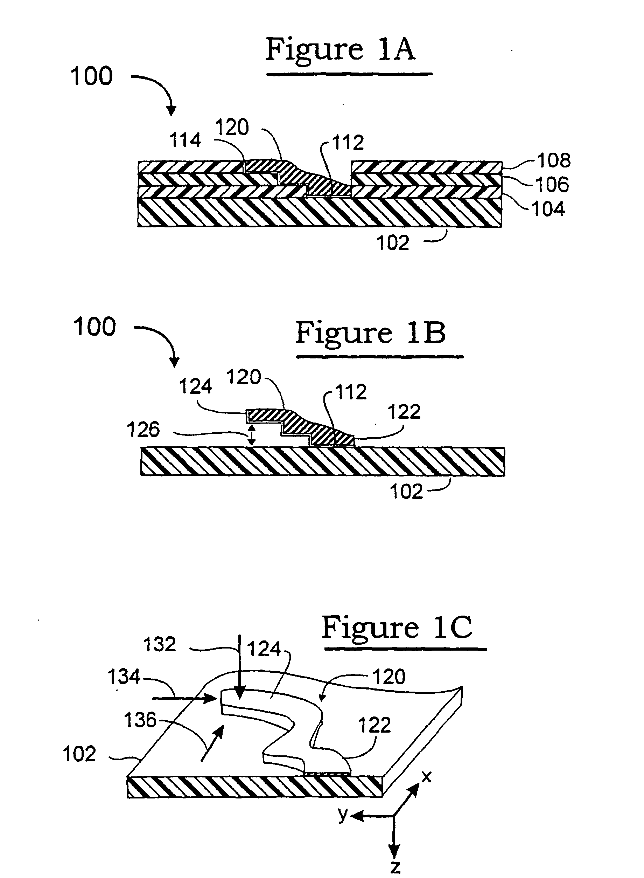

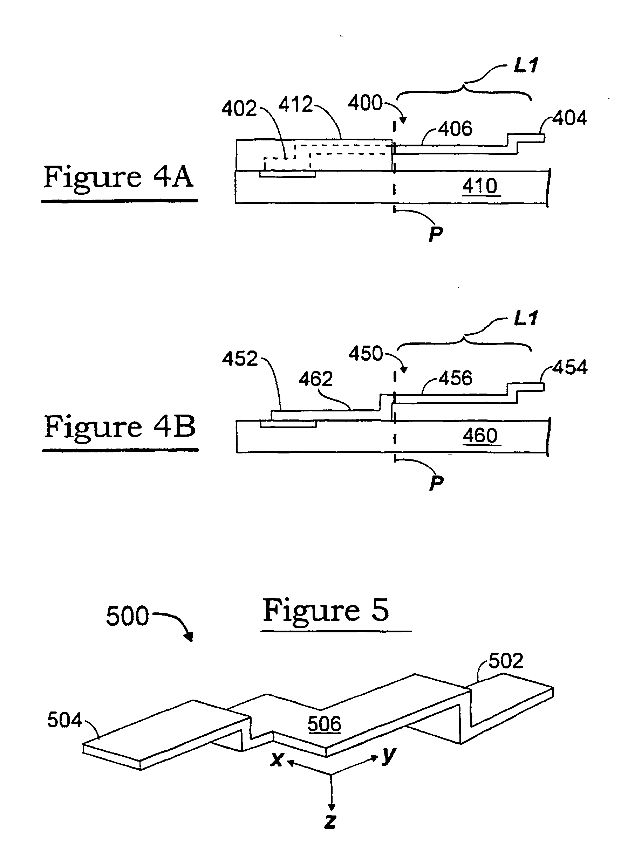

Commonly-owned, copending U.S. Provisional Patent Application No. **60/030,697** filed 13 Nov 96 discloses, for example at Figures 4A-4C thereof, a technique for fabricating free-standing resilient (spring) contact elements on an electronic component. Generally, a number of insulating layers having openings formed therein are aligned and "seeded" with a layer of conductive material. A mass of conductive material can then be formed (or deposited) in the seeded opening(s), such as by electroplating (or CVD, sputtering, electroless plating, etc.). After the insulating layers are removed, the masses can function as free-standing resilient contact structures which extend not only vertically above the surface of the component, but also laterally from the location whereat they are mounted. In this manner, the contact structures are readily engineered to be compliant in both the Z-axis as well as in the x-y plane (parallel to the surface of the component). This is described in greater detail hereinbelow with respect to **Figures 1A-1C.**

**Figure 1A** illustrates an exemplary technique 100 for fabricating one of a plurality of free-standing resilient (spring) contact elements on a substrate 102 which may be an active electronic component, including semiconductor devices, including semiconductor devices resident on a semiconductor wafer (not shown).

The substrate 102 has a plurality (one of may shown) or areas 112 on its surface whereat the spring contact elements will be fabricated. In the case of the substrate 102 being an electronic component (such as a semiconductor device), these areas 112 would be terminals (such as bond pads) of the electronic component.

Generally, the technique 100 involves applying a number (three shown) of patterned masking layers 104, 106 and 108 having openings onto the surface of the substrate. The layers are patterned to have openings (as shown) aligned with the areas 112, and the openings are sized and shaped so that an opening in a one layer (e.g., 108, 106) extends further from the area 112 than an opening in an underlying layer (e.g., 106, 104, respectively). In other words, the first layer 104 has an opening which is directly over the area 112. A portion of the opening in the second layer 106 is aligned over at least a portion of the opening in the first layer 104 and, conversely, a portion of the first layer 104 extends under a portion of the opening in the second layer 106. Similarly, a portion of the opening in the third layer 108 is aligned over at least a portion of the opening in the second layer 106 and, conversely, a portion of the second layer 106 extends under a portion of the opening in the third layer 108. The bottom portion of a given overall opening is directly over the selected area 112 and its top portion is elevated and laterally offset from its bottom portion. As will be discussed in greater detail hereinbelow, a conductive metallic material is deposited into the openings, and the masking layers are removed, resulting in a free-standing contact structure having been fabricated directly upon the substrate with its base end secured to the substrate 102 at the area 112 and its free end extending both above the surface of the substrate and laterally-displaced from the area 112.

If required, such as for electroplating, a very thin (e.g., 450 µm) "seed" layer of conductive material 114 such as titanium/tungsten (TiW) may be deposited into the openings. Then, a mass of conductive metallic material (e.g., nickel) 120 can be deposited by electroplating into the openings.

**Figures 1B and 1C** illustrate a resulting spring contact element 120 having its base end 122 adjacent the area 112, and its free-end (tip) 124 elevated in the z-axis above the surface of the substrate 102 as well as laterally offset in the x-axis and y-axis from the base end 122.

As best viewed in **Figure 1C,** the contact element 120 will react pressure applied in the z-axis at its tip end 124, as indicated by the arrow 124, such as would result from making a temporary pressure electrical connection with a terminal (not shown) of another electronic component (not shown). Compliance in the z-axis ensures that contact force (pressure) will be maintained, and also accommodates non-planarities (if any) between terminals (not shown) on the other electronic component (not shown). Such temporary electrical connections are useful for making temporary connections to the electronic component 102, such as for performing burn-in and/or testing of the component 102.

The tip end 124 is also free to move compliantly in the x- and y- directions, as indicated by the arrows 136 and 134, respectively. This would be important in the context of joining (by soldering, or brazing, or with a conductive adhesive) the tip end 124 to a terminal (not shown) of another electronic component (not shown) which has a different coefficient of thermal expansion than the substrate (component) 102. Such permanent electrical connections are useful for assemblies of electronic components, such as a plurality of memory chips (each of which is represented by the substrate 102) to another electronic component such as an interconnection substrate such as a printed circuit board ("PCB"; not shown).

By suitable choice of material and geometry, these fabricated masses 120 can function as free-standing resilient contact structures which have been fabricated with very precise dimensions and very precise spacings from one another. For example, tens of thousands of such spring contact elements (120) are readily precisely fabricated on a corresponding number of terminals on semiconductor devices which are resident on a semiconductor wafer (not shown).

In this manner, there has been shown a method of fabricating spring contact elements (120) directly on a substrate (102) such as an electronic component, such as a semiconductor device which may be resident on a semiconductor wafer, by applying at least one layer of masking material (104, 106, 108) on a surface of the substrate (102) and pattering the masking layer to have openings extending from areas (112) on the substrate to positions which are spaced above the surface of the substrate and which also are laterally and/or transversely offset from the areas 112); by optionally seeding (114) the openings; by depositing at least one layer of a conductive metallic material into the openings; and by removing the masking material so that the remaining conductive metallic material forms free-standing contact elements extending from the surface of the substrate, each contact element having a base end which is secured to a one of the areas of the substrate and having a tip end for making an electrical connection to a terminal of an electronic component.

### MATERIALS

The structures (spring contact elements) 120 are principally, preferably entirely, metallic, and may be formed (fabricated) as multilayer structures. Suitable materials for the one or more layers of the contact structures include but are not limited to:
nickel, and its alloys;
copper, cobalt, iron, and their alloys;
gold (especially hard gold) and silver, both of which exhibit excellent current-carrying capabilities and good contact resistivity characteristics;
elements of the platinum group;
noble metals;
semi-noble metals and their alloys, particularly elements of the palladium group and their alloys; and
tungsten, molybdenum and other refractory metals and their alloys.

In cases where a solder-like finish is desired, tin, lead, bismuth, indium and their alloys can also be used.

### AN EXEMPLARY APPLICATION (USE) FOR THE SPRING CONTACT ELEMENTS

As mentioned above, the spring contact elements (120) of the present invention are useful for effecting temporary electrical connections to the component (102) upon which the spring contact elements are fabricated, such as for burning-in and/or testing the components. Commonly-owned, copending U.S. Patent Application No. **08/784,862** filed 15 Jan 97 discloses at Figure 1A thereof, reproduced herein as **Figure 2A,** a system for performing wafer-level burn-in and test.

**Figure 2A** illustrates an exemplary system 200 for performing wafer-level burn-in and test of a plurality of semiconductor devices 200 (200a, 200b, 200c, 200d) resident on a semiconductor wafer. Spring contact elements 210 (compare 120) are fabricated on each of the semiconductor devices, and are illustrated in a highly schematic manner. Each device is shown having four of many such spring contact elements projecting (schematically) from its surface. The entire semiconductor wafer is suitably mounted on a thermally-controlled platen 204.

A test substrate includes an interconnection substrate 208 having a plurality of active electronic devices 206 (206a, 206b, 206c, 206d) mounted on its front surface. These devices are suitably application-specific integrated circuits (ASICs). A thermally-controlled platen 204a may be mounted to the back side of the interconnection substrate 208. The ASICs 206 are connected to the interconnection substrate 208 in any suitable manner, such as by bond wires (not shown). A host computer 216 and a power supply 218 are connected to the ASICs via the interconnection substrate 208. Suitable fixturing 212, 214 is provided so that the wafer (202) may be aligned and moved towards the interconnection substrate (208) until the spring contact elements 210 effect pressure connections with terminals on the front (bottom, as viewed) faces of the ASICs (206), whereupon the semiconductor devices (202) can be powered up, burned-in and tested, including simultaneously exercising all of the devices (202) on the wafer.

**Figure 2B**, corresponding to Figure 1B of commonly-owned, copending U.S. Patent Application No. **08/784,862** is a schematic illustration of a single one of the semiconductor devices 202a in contact with a corresponding single one of the ASICs 206a, and illustrates schematically that the spring contact elements (210) can be fabricated so that some of them (210a, 210b) are relatively long and others of them (210c, 210d) are relatively short, and so that some of them (210a, 210c) extend in a one direction from a central row of bond pads 207 (shown as squares) and others of them (210b, 210d) extend in an opposite direction from the central row of bond pads 207 so that the tip ends (shown as circles) of the spring contact elements are at a greater pitch (distance from one another) than their base ends.

### SIZING AND SHAPING THE SPRING CONTACT ELEMENTS

Inasmuch as the spring contact elements of the present invention are suitably formed using micromachining techniques such as photolithography and plating, both the shape and size of the spring contact elements are readily controlled to precise dimensions.

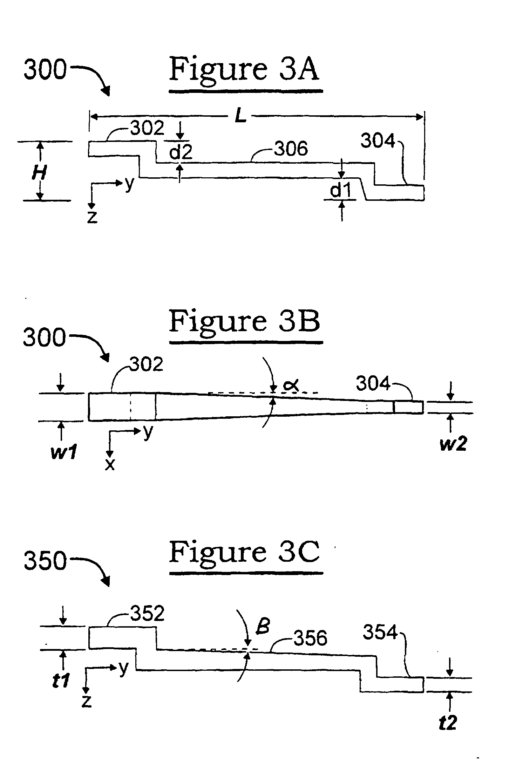

**Figures 3A-3C** are schematic illustrations of spring contact elements 300 and 350 (compare 120) fabricated according to the techniques of the present invention.

The spring contact element 300 of **Figures 3A and 3B** have a base end portion 302, a contact (tip) end portion 304, a main body portion 306 therebetween, an overall length "**L**" and an overall height "**H**". As illustrated, the main body portion 306 is offset a distance "**d2**" in a one direction from the base end portion 302, and is offset a distance "**d1**" in another direction from the contact end portion 304. For example, the distance "**d2**" would be determined by the thickness of a first masking layer (compare 104) and the distance "**d1**" would be determined by the thickness of a final masking layer (compare 108). As best viewed in the top schematic view of **Figure 3B,** the contact element 300 can be tapered provided with a widthwise taper "**α**" so that it is narrower (width "**w1**") at its contact end 304 than at its base end 302 (width "**w2**").

**Figure 3C** is a schematic representation of a similar (to the contact element 300) spring contact element 350 that has a base end portion 352 (compare 302), a contact (tip) end portion 354 (compare 304), and a main body portion 356 (compare 306) therebetween. In this example, the contact element 350 can be tapered provided with a thickness taper "β" so that it is thinner (thickness "**t2**") at its contact end 304 than at its base end 302 (thickness "**t1**").

### EXEMPLARY DIMENSIONS

The spring contact elements of the present invention are particularly well suited to making interconnections between microelectronic components. Using the parameters set forth hereinabove, suitable dimensions for the spring contact element are :

| dimension | range | preferred |
|---|---|---|
| L | 10 - 1000 mils (254 - 25400 µm) | 60 - 100 mils |
| H | 4 - 40 mils (101.6 - 1016 µm) | 5 - 12 mils |
| d1 | 3 - 15 mils (76.2 - 351 µm) | 7 ± 1 mils |
| d2 | 0 - 15 mils (0 - 351 µm) | 7 ± 1 mils |
| w1 | 3 - 20 mils (76.2 - 508 µm) | 8 - 12 mils |
| w2 | 1 - 10 mils (25.4 - 254 µm) | 2 - 8 mils |
| t1 | 1 - 10 mils (25.4 - 254 µm) | 2 - 5 mils |
| t2 | 1 - 10 mils (25.4 - 254 µm) | 1 - 5 mils |
| α | 0 - 30° | 2 - 6° |
| β | 0 - 30° | 0 - 6° |

### TAILORING THE BEHAVIOR OF THE SPRING CONTACT ELEMENTS

The possibilities of having spring contact elements of different lengths than one another has been discussed hereinabove (see, e.g., **Figure 2B**). In order that a plurality of different length spring contact elements resident on a single electronic component all exhibit the same spring constant (k), it is possible, but not preferred, to "customize" the taper angles for each contact element in the manner discussed with respect to **Figures 3B and 3C**. Another, more facile way to uniformize the spring constants of different length spring contact elements is described with respect to **Figures 4A and 4B.**

In either case, namely whether the base end (302) is wider **(Figure 3B**) than the tip end (304), or the base end (352) is thicker (**Figure 3C**) than the tip end (354), the base end (302, 352) has a larger cross-section than the tip end (304, 354).

**Figure 4A** illustrates a spring contact element 400 which has been fabricated on an electronic component 410. The spring contact element 400 has a base end 402 (compare 302), a contact end 404 (compare 304), a main body portion 406 (compare 306), and an overall length (L) between the base end and the contact end. In order to make the spring contact element 400 "behave" as though it were shorter (e.g., to exhibit behavior similar to shorter spring contact elements on the same component) the base end 402 and a contiguous portion of the main body portion 406 are encapsulated with a suitable encapsulant (e.g., epoxy) to "rigidize" the spring contact element up to a point "**P**" which is located a distance "**L1**" from the contact end 404 along the body portion 406.

**Figure 4B** illustrates another technique for tailoring the mechanical performance of a spring contact element 450 (compare 400) which has been fabricated on an electronic component 460 (compare 410). The spring contact element 450 has a base end 452 (compare 402), a contact end 454 (compare 404), a main body portion 456 (compare 406), and an overall length (L) between the base end and the contact end. In order to make the spring contact element 450 "behave" as though it were shorter (e.g., to exhibit behavior similar to shorter spring contact elements on the same component) a portion of the main body portion 456 which is contiguous with the base end 452 "follows" the surface of the component 460 to a point "**P**" whereat it "steps up" so that it is elevated above the surface of the component. As in the previous example (400), the point "**P**" is located a distance "**L1**" from the contact end 454 along the body portion 456.

The portion of the spring contact element 450 that "follows" along the surface of the component 460 is the "tail" end 462 of the spring contact element 450. Aside from employing this technique (**Figure 4B**) to uniformize spring constant, it within the scope of this invention that the tail ends of the spring contact elements formed according to the invention extend in any direction along the surface of the component (460) to effect "routing" from a given terminal on the component. In this manner, for example, a peripheral array of component terminals can be transformed to an area array of tips (454), and vice-versa. It is also within the scope of this invention that the "tails" (462) of two or more spring contact elements (450) can cross over one another to facilitate more complex routing schemes. Reference is also made to Figure 3D of the aforementioned **PCT/US95/14885,** which discusses a form of routing in conjunction with spring contact elements.

### ANOTHER EMBODIMENT

As is evident, a great degree of control can be exerted in the size, shape and orientation of the spring contact elements fabricated according to the present invention.

**Figure 5** illustrates a spring contact element (compare 120) having a base end 502, a contact end 504, and a body portion 506 therebetween. In this example, the body portion "jogs" in the x-y plane (parallel to the surface of the component upon which it is fabricated) so that the contact end 504 is at different x, y and z coordinates than the base end 502. In other words, as the body portion 506 traverses the y-axis, it shifts (jogs) in the x-axis.

### CONTROLLED IMPEDANCE

For use in probing semiconductor devices, particularly for performing at-speed testing, it is advantageous that the spring contact element have controlled impedance.

**Figures 6A-6C** illustrate a technique 600 for achieving controlled impedance in a spring contact element, according to the invention.

In a first step, best viewed in **Figure 6A**, a spring contact element 600 (compare 400) is mounted by its base end 602 (compare 402) to a terminal 612 of an electronic component 610 (compare 410). The contact tip end 604 (compare 404) is elevated above the surface of the component 610. The spring contact structure has a central body portion 606 (compare 406) between its base and tip ends.

In a next step, best viewed in **Figure 6B,** the tip end 604 of the spring contact element is masked (not shown), and a suitable thin (e.g., 1-10 µm) insulating layer 620, such as parylene, is deposited, such as by vapor deposition, onto all but the tip end 604 of the spring contact element, and adjacent surface of the electronic component.

In a next step, best viewed in **Figure 6B,** while the tip end 604 of the spring contact element is still masked (not shown), a suitable thin (e.g., less than 0.25 mm) layer 622 of conductive material, such as any of the conductive metal material described herein, is deposited, such as by sputtering, onto all but the tip end 604 of the spring contact element, and adjacent surface of the electronic component. Finally, the tip end 604 is unmasked. This results in the central body portion 606 of the spring contact element being enveloped by a conductive layer 622, with an insulating layer 620 therebetween.

The conductive layer 622 is suitably connected to ground to function as a ground plane and control the impedance of the resulting spring contact element. For example, as best viewed in Figure 6B, the component 610 is provided with a second terminal 614 which is electrical ground. This terminal 614 is suitably masked along with the tip end 604 of the spring contact element prior to applying the insulating layer 620, so that the subsequent conductive layer 622 will also deposit thereon and be connected thereto.

Evidently, this thicknesses of the layers 620 and 622 need only be sufficient to be continuous, and to provide the sought after controlled impedance, and should not be so thick as to interfere with the mechanical operation of the spring contact element. The representations in **Figures 6B and 6C** are not drawn to scale.

Although the invention has been illustrated and described in detail in the drawings and foregoing description, the same is to be considered as illustrative and not restrictive in character - it being understood that only preferred embodiments have been shown and described. Undoubtedly, many other "variations" on the "themes" set forth hereinabove will occur to one having ordinary skill in the art to which the present invention most nearly pertains, and such variations are intended to be within the scope of the invention, as disclosed herein.

For example, the resulting spring contact elements may be heat-treated to enhance their mechanical characteristics. Also, any heat incident to permanently connecting (e.g., by brazing) the spring contact elements to a component can advantageously be employed to "heat treat" the material of the spring contact element.

## Claims

1. Method of fabricating spring contact elements on a substrate, comprising:
applying at least one layer of masking material (104,106,108) on a surface of a substrate (102, 202, 410, 610, 460) and patterning the masking layer to have openings extending from areas (112) on the substrate to positions which are above the surface of the substrate and which also are laterally and/or transversely offset from the areas (112);
depositing at least one layer of a conductive metallic material into the openings; and
removing the masking material (104,106,108) so that the remaining conductive metallic material forms elongate free-standing contact elements (120, 210, 300, 400, 500, 600) extending from the surface of the substrate (102, 202, 410, 610, 460), each contact element having a base end which is secured to a one of the areas of the substrate and having a free-standing tip end for making electrical connections.

2. Method, according to claim 1, further comprising:
prior to depositing the at least one layer of conductive metallic material, seeding (114) the openings in the at least one layer of masking material (104, 106, 108).

3. Method, according to claim 1, wherein:
the substrate is an electronic component.

4. Method, according to claim 1, wherein:
the substrate is a semiconductor device.

5. Method, according to claim 1, wherein:
the substrate is a semiconductor wafer.

6. Method, according to claim 1, further comprising:
forming the openings in the at least one masking layer so that the base ends of the resulting spring contact elements have a larger cross-section than the tip ends of the resulting spring contact elements.

7. A microelectronic spring contact element, comprising:
an elongate member of length "**L**" having a base end portion (112, 302, 352, 402, 452, 602), a contact end portion (124, 302, 404) opposite the base end portion, and a central body portion (306, 356) contiguous with each of the base and contact end portions;
the contact end portion (124, 304, 354, 404, 454, 504, 604) is offset in a first direction from the central portion (306, 356) by a distance "**d1**";
the base end portion is offset in a second direction opposite the first direction from the central portion by a distance "**d2**";
wherein:
the base end portion is securely fixed to an area of a first electronic component (102, 410, 460, 610);
the contact end portion is adapted in use to make a pressure connection with a second electronic component; and
the base end portion (112, 302, 352, 402, 452, 602) and the contact end portion (124, 304, 354, 404, 454, 504, 604) are laterally and vertically offset from each other;
**characterized in that**
the lateral length (L) between the outer end of the contact end portion and the outer end of the base end portion is in the range of 1524 - 2540 µm (60-100 mils); and
the overall height (H) is in the range of 101.6 - 1016 µm (4-40 mils).

8. The microelectronic spring contact element, according to claim 7, wherein:
the spring contact element is thicker at the base end portion (112, 302, 352, 402, 452, 602) than at the contact end portion (124, 304, 354, 404, 454, 504, 604).

9. The microelectronic spring contact element, according to claim 7 or 8, wherein:
the spring contact element is wider at the base end portion than at the contact end portion.

10. The microelectronic spring contact element, according to claim 7, 8 or 9, wherein:
the overall height "**H**" is the sum of "**d1**", "**d2**" and a thickness at the central body portion of the member.

11. The microelectronic spring contact element, according to any of claims 7 to 10, wherein:
the overall height "**H**" is in the range of 127 - 304,8 µm (5-12 mils).

12. The microelectronic spring contact element, according to claim 7, wherein the spring contact element has one or more layers selected from the materials consisting of:
nickel, and its alloys;
copper, cobalt, iron, and their alloys;
gold (especially hard gold) and silver;
elements of the platinum group;
noble metals;
semi-noble metals and their alloys, particularly elements of the palladium group and their alloys;
tungsten, molybdenum and other refractory metals and their alloys; and
tin, lead, bismuth, indium and their alloys.

13. A semiconductor device having a plurality of terminals (bond pads) on a surface thereof, further comprising:
a plurality of spring contact elements (120, 300, 350, 400, 450) according to any of claims 7 to 12.

14. The semiconductor device, according to claim 13, wherein:
each spring contact element has a tail portion contiguous with the base end; and
the tail portions of the spring contact elements effect routing.

15. The semiconductor device, according to claim 13, wherein the spring contact elements are made by:
applying at least one layer of masking material on the surface of the semiconductor device;
pattering the masking layer to have openings extending from bond pads on the semiconductor device to positions which are above the surface of the semiconductor device and which also are laterally and/or transversely offset from the bond pads;
depositing at least one layer of a conductive metallic material into the openings; and
removing the masking material so that the remaining conductive metallic material forms free-standing spring contact elements.

16. A semiconductor wafer, comprising:
a plurality of semiconductor devices resident thereon;
a plurality of spring contact elements according to any of claims 7 to 12 fabricated directly on the semiconductor devices resident on the semiconductor wafer;
wherein the semiconductor devices resident on the semiconductor wafer are ready for burn-in and testing prior to being singulated from the semiconductor wafer.

17. The semiconductor wafer, according to claim 16, wherein the spring contact elements are made by:
applying at least one layer of masking material on the surface of the semiconductor wafer;
pattering the masking layer to have openings extending from bond pads on the semiconductor devices resident on the semiconductor wafer to positions which are above the surface of the semiconductor wafer and which also are laterally and/or transversely offset from the bond pads;
depositing at least one layer of a conductive metallic material into the openings; and
removing the masking material so that the remaining conductive metallic material forms free-standing spring contact elements.

## Patentansprüche

1. Verfahren zur Herstellung von Federkontaktelementen auf einem Substrat, umfassend:
Aufbringen mindestens einer Schicht aus Maskierungsmaterial (104, 106, 108) auf eine Oberfläche eines Substrats (102, 202, 410, 610, 460) und Strukturieren der Maskierungsschicht, so dass sie Öffnungen aufweist, die sich von Flächen (112) auf dem Substrat zu Positionen erstrecken, die oberhalb der Oberfläche des Substrats liegen und die auch seitlich und/oder quer zu den Flächen (112) versetzt sind;
Abscheiden mindestens einer Schicht aus einem leitenden Metallmaterial in den Öffnungen; und
Entfernen des Maskierungsmaterials (104, 106, 108), so dass das verbleibende leitende Metallmaterial längliche, freistehende Kontaktelemente (120, 210, 300, 400, 500, 600) bildet, die sich von der Oberfläche des Substrats (102, 202, 410, 610, 460) erstrecken, wobei jedes Kontaktelement ein Basisende aufweist, das an einer der Flächen des Substrats befestigt ist, und ein freistehendes Spitzenende zur Herstellung von elektrischen Verbindungen aufweist.

2. Verfahren nach Anspruch 1, welches ferner umfasst:
vor dem Abscheiden der mindestens einen Schicht aus leitendem Metallmaterial, Impfen (114) der Öffnungen in der mindestens einen Schicht aus Maskierungsmaterial (104, 106, 108).

3. Verfahren nach Anspruch 1, wobei:
das Substrat ein elektronisches Bauteil ist.

4. Verfahren nach Anspruch 1, wobei:
das Substrat ein Halbleiterbauelement ist.

5. Verfahren nach Anspruch 1, wobei:
das Substrat ein Halbleiterwafer ist.

6. Verfahren nach Anspruch 1, welches ferner umfasst:
Ausbilden der Öffnungen in der mindestens einen Maskierungsschicht so, dass die Basisenden der resultierenden Federkontaktelemente einen größeren Querschnitt aufweisen als die Spitzenenden der resultierenden Federkontaktelemente.

7. Mikroelektronisches Federkontaktelement mit:
einem länglichen Element mit der Länge "L" mit einem Basisendteil (112, 302, 352, 402, 452, 602), einem Kontaktendteil (124, 302, 404) entgegengesetzt zum Basisendteil und einem zentralen Körperteil (306, 356) benachbart zu jedem des Basis- und des Kontaktendteils;
wobei der Kontaktendteil (124, 304, 354, 404, 454, 504, 604) in einer ersten Richtung vom zentralen Teil (306, 356) um einen Abstand "d1" versetzt ist;
der Basisendteil in einer zur ersten Richtung entgegengesetzten zweiten Richtung vom zentralen Teil um einen Abstand "d2" versetzt ist;
wobei:
der Basisendteil sicher an einer Fläche eines ersten elektronischen Bauteils (102, 410, 460, 610) befestigt ist;
der Kontaktendteil bei der Verwendung dazu ausgelegt ist, eine Druckverbindung mit einem zweiten elektronischen Bauteil herzustellen; und
der Basisendteil (112, 302, 352, 402, 452, 602) und der Kontaktendteil (124, 304, 354, 404, 454, 504, 604) seitlich und vertikal gegeneinander versetzt sind;
**dadurch gekennzeichnet, dass**
die seitliche Länge (L) zwischen dem äußeren Ende des Kontaktendteils und dem äußeren Ende des Basisendteils im Bereich von 1524 - 2540 µm (60-100 mils) liegt; und
die Gesamthöhe (H) im Bereich von 101,6 - 1016 µm (4-40 mils) liegt.

8. Mikroelektronisches Federkontaktelement nach Anspruch 7, wobei:
das Federkontaktelement am Basisendteil (112, 302, 352, 402, 452, 602) dicker ist als am Kontaktendteil (124, 304, 354, 404, 454, 504, 604).

9. Mikroelektronisches Federkontaktelement nach Anspruch 7 oder 8, wobei:
das Federkontaktelement am Basisendteil breiter ist als am Kontaktendteil.

10. Mikroelektronisches Federkontaktelement nach Anspruch 7, 8 oder 9, wobei:
die Gesamthöhe "**H**" die Summe von "d1", "d2" und einer Dicke am zentralen Körperteil des Elements ist.

11. Mikroelektronisches Federkontaktelement nach einem der Ansprüche 7 bis 10, wobei:
die Gesamthöhe "H" im Bereich von 127 - 304,8 µm (5-12 mils) liegt.

12. Mikroelektronisches Federkontaktelement nach Anspruch 7, wobei das Federkontaktelement eine oder mehrere Schichten aufweist, die aus den Materialien ausgewählt sind, die aus folgendem bestehen:
Nickel und seinen Legierungen;
Kupfer, Kobalt, Eisen und ihren Legierungen;
Gold (insbesondere hartem Gold) und Silber;
Elementen der Platingruppe;
Edelmetallen;
Halbedelmetallen und ihren Legierungen, insbesondere Elementen der Palladiumgruppe und ihren Legierungen;
Wolfram, Molybdän und anderen schwer schmelzenden Metallen und ihren Legierungen; und
Zinn, Blei, Wismut, Indium und ihren Legierungen.

13. Halbleiterbauelement mit einer Vielzahl von Anschlüssen (Bondkontaktstellen) auf einer Oberfläche desselben, welches ferner umfasst:
eine Vielzahl von Federkontaktelementen (120, 300, 350, 400, 450) nach einem der Ansprüche 7 bis 12.

14. Halbleiterbauelement nach Anspruch 13, wobei:
jedes Federkontaktelement einen Endteil benachbart zum Basisende aufweist; und
die Endteile der Federkontaktelemente eine Leitweglenkung bewirken.

15. Halbleiterbauelement nach Anspruch 13, wobei die Federkontaktelemente hergestellt werden durch:
Aufbringen mindestens einer Schicht aus Maskierungsmaterial auf die Oberfläche des Halbleiterbauelements;
Strukturieren der Maskierungsschicht, so dass sie Öffnungen aufweist, die sich von Bondkontaktstellen auf dem Halbleiterbauelement zu Positionen erstrecken, die oberhalb der Oberfläche des Halbleiterbauelements liegen und die auch seitlich und/oder quer zu den Bondkontaktstellen versetzt sind;
Abscheiden mindestens einer Schicht aus einem leitenden Metallmaterial in den Öffnungen; und
Entfernen des Maskierungsmaterials, so dass das verbleibende leitende Metallmaterial freistehende Federkontaktelemente bildet.

16. Halbleiterwafer mit:
einer Vielzahl von auf diesem befindlichen Halbleiterbauelementen;
einer Vielzahl von Federkontaktelementen nach einem der Ansprüche 7 bis 12, die direkt auf den Halbleiterbauelementen, die sich auf dem Halbleiterwafer befinden, hergestellt sind;
wobei die auf dem Halbleiterwafer befindlichen Halbleiterbauelemente zum Voraltern und Prüfen, bevor sie vom Halbleiterwafer vereinzelt werden, bereit sind.

17. Halbleiterwafer nach Anspruch 16, wobei die Federkontaktelemente hergestellt werden durch:
Aufbringen mindestens einer Schicht aus Maskierungsmaterial auf die Oberfläche des Halbleiterwafers;
Strukturieren der Maskierungsschicht, so dass sie Öffnungen aufweist, die sich von Bondkontaktstellen auf den Halbleiterbauelementen, die sich auf dem Halbleiterwafer befinden, zu Positionen erstrecken, die oberhalb der Oberfläche des Halbleiterwafers liegen und die auch seitlich und/oder quer zu den Bondkontaktstellen versetzt sind;
Abscheiden mindestens einer Schicht aus einem leitenden Metallmaterial in den Öffnungen; und
Entfernen des Maskierungsmaterials, so dass das verbleibende leitende Metallmaterial freistehende Federkontaktelemente bildet.

## Revendications

1. Procédé de fabrication d'éléments de contact à ressort, sur un substrat, comprenant :
l'application d'au moins une couche de matériau de masquage (104, 106, 108) sur une surface d'un substrat (102, 202, 410, 610, 460) et la mise en motif de la couche de masquage pour avoir des ouvertures s'étendant depuis des zones (112) du substrat vers des positions situées au-dessus de la surface du substrat et qui, également, sont décalées latéralement et/ou transversalement par rapport aux zones (112);
la déposition d'au moins une couche d'un matériau métallique conducteur dans les ouvertures; et
l'enlèvement du matériau de masquage (104, 106, 108), de manière que le matériau métallique conducteur subsistant forme des éléments de contact en saillie (120, 210, 300, 400, 500, 610) allongés, s'étendant depuis la surface du substrat (102, 202, 410, 610, 460), chaque élément de contact ayant une extrémité de base, fixée à une des zones du substrat, et ayant une extrémité de bout en saillie libre pour établir des connexions électriques.

2. Procédé selon la revendication 1, comprenant en outre :
avant la déposition de la au moins une couche de matériau métallique conducteur, l'ensemencement (114) des ouvertures situées dans la au moins une couche de matériau de masquage (104, 106, 108).

3. Procédé selon la revendication 1, dans lequel :
le substrat est un composant électronique.

4. Procédé selon la revendication 1, dans lequel :
le substrat est un dispositif à semi-conducteur.

5. Procédé selon la revendication 1, dans lequel :
le substrat est une tranche de semi-conducteur.

6. Procédé selon la revendication 1, comprenant en outre :
le formage des ouvertures dans la au moins une couche de masquage, de manière que les extrémités de base des éléments de contact élastiques à ressort résultant aient une section transversale plus grande que les extrémités de bout des éléments de contact à ressort résultants.

7. Un élément de contact à ressort microélectronique, comprenant :
un organe allongé de longueur "L", ayant une partie d'extrémité de base (112, 302, 352, 402, 452, 602), une partie d'extrémité de contact (124, 302, 404) opposée à la partie d'extrémité de base, et une partie de corps central (306, 356), contiguë à chacune des parties d'extrémité de base et de contact;
la partie d'extrémité de contact (124, 304, 354, 404, 454, 504, 604) est décalée dans une première direction par rapport à la partie centrale (306, 356), d'une distance "d1";
la partie d'extrémité de base est décalée dans une deuxième direction, opposée à la première direction par rapport à la partie centrale, d'une distance "d2";
dans laquelle :
la partie d'extrémité de base est fixée de façon sûre à une zone d'un premier composant électronique (102, 410, 460, 650);
la partie d'extrémité de contact est adaptée en utilisation pour établir une connexion sous pressage, avec un deuxième composant électronique, et
la partie d'extrémité de base (112, 302, 352, 402, 452, 602) et la partie d'extrémité de contact (124, 304, 354, 404, 454, 604) sont décalées latéralement et verticalement les unes des autres;
**caractérisé en ce que**
la longueur latérale (L), entre l'extrémité extérieure de la partie d'extrémité de contact et l'extrémité extérieure de la partie d'extrémité de base, est dans la plage de 1524 à 2540 µm (60 à 1000 mils);
et
la hauteur globale (**H**) est dans la plage de 101.6 à 1016 µm (4 à 40 mils).

8. L'élément de contact à ressort microélectronique selon la revendication 7, dans lequel :
l'élément à contact à ressort est plus épais à la partie d'extrémité de base (112, 302, 352, 402, 452, 602) qu'à la partie d'extrémité de contact (124, 304, 354, 404, 454, 504, 604).

9. L'élément de contact à ressort microélectronique selon la revendication 7 ou 8, dans lequel l'élément de contact à ressort est plus large à la partie d'extrémité de base qu'à la partie d'extrémité de contact.

10. L'élément de contact à ressort microélectronique selon la revendication 7, 8 ou 9, dans lequel :
la hauteur globale (H) est la somme de "d1", "d2" et d'une épaisseur à la partie centrale de l'élément.

11. L'élément de contact à ressort microélectronique selon l'une quelconque des revendications 7 à 10, dans lequel
la hauteur globale (H) est dans la plage de 127 à 304,8 µm (5 à 12 mils)

12. L'élément de contact à ressort microélectronique selon la revendication 7, dans lequel l'élément de contact à ressort comprend une ou plusieurs couches, sélectionnées dans les matériaux composés de :
nickel et ses alliages,
cuivre, cobalt, fer et leurs alliages,
or (spécialement or dur) et argent;
éléments du groupe du platine;
métaux nobles;
métaux semi-nobles et leurs alliages, en particulier des éléments du groupe du palladium et leurs alliages;
tungstène, molybdène et autres matériaux réfractaires et leurs alliages; et
étain, plomb, bismuth, indium et leurs alliages.

13. Un dispositif à semi-conducteur, comprenant une pluralité de bornes (plages de liaison) sur une surface de celui-ci, comprenant en outre :
une pluralité d'éléments de contact à ressort, selon l'une quelconque des revendications 7 à 12.

14. Le dispositif à semi-conducteur selon la revendication 13, dans lequel :
chaque élément de contact à ressort comprend une partie queue, contiguë à l'extrémité de base; et
les parties queue des éléments de contact à ressort assurent l'acheminement.

15. Le dispositif à semi-conducteur selon la revendication 13, dans lequel les éléments de contact à ressort sont produits par :
application d'au moins une couche de matériau de masquage sur la surface du dispositif à semi-conducteur;
mise en motif de la couche de masquage pour avoir des ouvertures s'étendant depuis des plages de liaison du dispositif à semi-conducteur vers des positions situées au-dessus de la surface du dispositif à semi-conducteur et qui, également, sont décalées latéralement et/ou transversalement par rapport aux plages de liaison;
déposition d'au moins une couche d'un matériau métallique conducteur dans les ouvertures; et
enlèvement du matériau de masquage, de manière que le matériau métallique conducteur subsistant forme des éléments de contact en saillie libre.

16. Une tranche à semi-conducteur, comprenant :
une pluralité de dispositifs à semi-conducteur résidents sur elle;
une pluralité d'éléments de contact à ressort selon l'une quelconque des revendications 1 à 12, fabriqués directement sur les dispositifs à semi-conducteur résidents sur la tranche à semi-conducteur;
dans laquelle les dispositifs à semi-conducteur résidents sur la tranche à semi-conducteur sont prêtes pour subi un vieillissement artificiel et des tests, avant d'être individualisés vis à vis de la tranche à semi-conducteur.

17. Une tranche à semi-conducteur selon la revendication 16, dans laquelle les éléments de contact à ressort sont produits par :
application d'au moins une couche de matériau de masquage sur la surface du dispositif à semi-conducteur;
mise en motif de la couche de masquage pour avoir des ouvertures s'étendant depuis des plages de liaison sur les dispositifs à semi-conducteur résidents sur la tranche à semi-conducteur, vers des positions situées au-dessus de la surface de la tranche à semi-conducteur et qui, également, sont décalées latéralement et/ou transversalement par rapport aux plages de liaison;
déposition d'au moins une couche d'un matériau métallique conducteur dans les ouvertures; et
enlèvement du matériau de masquage, de manière que le matériau métallique conducteur subsistant forme des éléments de contact en saillie libre.
